# EUROPÄISCHE PATENTSCHRIFT

(11) **EP 2 364 431 B1**
(45) Veröffentlichungstag und Bekanntmachung des Hinweises auf die Patenterteilung: **03.10.2012**
(21) Anmeldenummer: 09804238.5
(22) Anmeldetag: 27.11.2009
(51) Int. Cl.: G01B 21/14, G01B 21/20, G06T 17/00

(54) **VERFAHREN ZUR ÜBERPRÜFUNG DER DRIFTBARKEIT VON METALLISCHEN ROHREN**
METHOD FOR TESTING THE DRIFTABILITY OF METAL TUBES
PROCÉDÉ DE CONTRÔLE DE L'APTITUDE À L'EXAMEN INTERNE DE TUBES MÉTALLIQUES

(30) Priorität: 03.12.2008 DE 102008060391
(43) Veröffentlichungstag der Anmeldung: 14.09.2011
(73) Patentinhaber: V & M Deutschland GmbH, 40472 Düsseldorf (DE)
(72) Erfinder: GROOS, Andreas, 47509 Rheurdt (DE); NITSCHE, Stefan, 45475 Mülheim (DE)
(74) Vertreter: Meissner, Peter E.
(86) Internationale Anmeldenummer: PCT/DE2009/001708
(87) Internationale Veröffentlichungsnummer: WO 2010/063277

(56) Entgegenhaltungen:
- GB-A- 2 064 121
- US-A- 4 354 379

## Beschreibung

Die Erfindung betrifft ein Verfahren zur Überprüfung der Driftbarkeit von metallischen Rohren gemäß dem Oberbegriff des Patentanspruches 1.

In diversen Kundenspezifikatione/Regelwerken wird vor der Auslieferung von Rohren ein sogenanntes "Driften" verlangt, bei dem ein zylindrischer Körper einer definierten Länge durch das Rohr hindurchgeführt wird. Hierbei wird der Prüfkörper durch das Rohr gezogen, geschoben oder geschossen. Dieser Test ist beispielsweise für Bohrrohre in der Ölförderung wichtig, weil dort ein mit einem definierten Durchmesser versehener Bohrkopf bis an die Bohrstelle hindurchgeführt werden muss.

Durch das Driften von Rohren wird sichergestellt, dass ein vorgegebener Innendurchmesser in Kombination mit einer Mindestgeradheit eingehalten wird. Ein Driftkörper ist z.B. aus der GB2064121 bekannt. US-4354379 beschreibt ein Drifttest verfahren.

Bleibt der Driftkörper im Rohr stecken, wird entschieden, ob ein Nacharbeiten, z. B. durch Ausschleifen, erfolgen kann, oder ob das Rohr einem anderen Auftrag zugeordnet werden kann oder möglicherweise sogar verschrottet werden muss.

Diese Drift-Tests sind einerseits sehr kosten- und zeitaufwändig und haben zudem noch den Nachteil, dass sie außerhalb des üblichen Rohr-Fertigungsflusses erfolgen müssen.

Die Test-Ergebnisse stehen daher erst zu einem sehr späten Zeitpunkt im Fertigungsablauf zur Verfügung und eventuell notwendige Änderungen der Fertigungsparameter können erst sehr spät vorgenommen werden. Ein erhöhter Ausfall bzw. vermehrte Nacharbeit an Rohren ist die Folge.

Ein weiterer Nachteil bei Drift-Tests sind im Rohr festsitzende Driftkörper, die einen Stillstand der Prüfanlage verursachen und kostenintensive Störzeiten zur Folge haben. Aufgabe der Erfindung ist es, ein Verfahren anzugeben, das einerseits die kundenspezifischen Anforderungen bezüglich des Driftens erfüllt, andererseits aber die beschriebenen Nachteile vermeidet.

Erfindungsgemäß wird diese Aufgabe entsprechend den Merkmalen des Anspruches 1 gelöst. Vorteilhafte Weiterbildungen sind Gegenstand des Anspruchs 2.

Das erfindungsgemäße Verfahren ist dadurch gekennzeichnet, dass anstelle der physischen Driftoperation ein virtuelles Driften vorgenommen wird, wobei unter Verwendung von zuvor ermittelten ortsgenauen Messdaten für den Außendurchmesser und die Wanddicke über den Umfang und die gesamte Rohrlänge sowie Messdaten oder angenommenen Werten für die Geradheit eine vollständige geometrische Beschreibung des Rohres in Form einer dreidimensionalen Abbildung erfolgt und anschließend mittels mathematischer Simulation ein virtueller zylindrischer Driftkörper mit vorgegebener Länge und vorgegebenem Durchmesser virtuell durch das Rohr geschoben wird, wobei über einen Vergleich von ortsgleichen Geometriewerten von Rohr und Driftkörper eine Aussage über die Driftbarkeit des Rohres abgeleitet wird.

Die Kemidee des erfindungsgemäßen Verfahrens besteht somit darin, dass anstelle eines physischen Drift-Tests am realen Rohr ein virtuelles Driften unter Verwendung von Messdaten aus der vollständigen geometrischen Beschreibung des selben Rohres durchgeführt wird.

Die Kosten für die Prüfung der Driftbarkeit werden, da diese nur noch virtuell erfolgt, drastisch reduziert. Außerdem stehen die Ergebnisse der Prüfung sehr schnell zur Verfügung, so dass Fertigungsparameter sehr zeitnah geändert werden können, wodurch das Nacharbeiten von Rohren bzw. deren Ausfall deutlich reduziert werden und damit zusätzlich erhebliche Kosten eingespart werden.

Zur Durchführung des Verfahrens wird in vorteilhafter Weise auf bereits vorhandene Messdaten von den zerstörungsfreien Prüfungen der zu driftenden Rohre zurückgegriffen, bei denen Wanddicken und Durchmesser und gegebenenfalls die Mittelpunktsposition, d. h. die Geradheit, ermittelt wurden und deren Koordination eine ortsgetreue Korrelation bezüglich der Längsposition am Rohr und des Umfangs zulassen.

Aus diesen Messwerten wird erfindungsgemäß eine geometrische Beschreibung der Rohres, d. h. ein Abbild in dreidimensionaler Form, erzeugt.

Durch dieses Abbild des Rohres wird dann virtuell ein zylindrischer Driftkörper in einer vorgegebenen Länge und mit vorgegebenem Durchmesser mittels einer mathematischen Simulation durchgeführt und die Driftbarkeit beurteilt.

Dies kann beispielsweise durch eine scheibenweise Betrachtung der Rohrinnengeometrie erfolgen. Wenn die mögliche räumliche Verschiebung des Scheibenmittelpunktes über die vorgegebene Driftlänge gesammelt und hierdurch eine Ausgleichsgerade gelegt wird, lässt sich die Driftbarkeit des Rohres Stück für Stück betrachten.

Liegen für das Rohr keine die Geradheit kennzeichnenden Mittelpunktspositionen in Form von Messwerten vor, so kann das erfindungsgemäße Verfahren dennoch durchgeführt werden. Es wird jedoch in der Aussage etwas ungenauer sein, da in diesem Fall für die Geradheit der mit Toleranzen versehene zugesicherte Wert gemäß Kundenspezifikation angenommen wird.

In einer vorteilhaften Weiterbildung der Erfindung lassen sich durch Iteration des beschriebenen Vorganges verschiedene Durchmesser und/oder Längen des Driftkörpers überprüfen. Diese Frage tritt wiederholt im Fertigungsprozess auf, wenn sich beispielsweise die Kundenanforderungen entsprechend ändem.

Mit dem erfindungsgemäßen Verfahren kann mit Hilfe der Simulation gezielt festgestellt werden, an welcher Stelle der Driftdom stecken bleiben würde. Diese Information ermöglicht eine gezielte Reparatur z. B. durch Rückschnitt oder Innenschleifen.

Die Vorteile der Erfindung lassen sich wie folgt zusammenfassen:
- Verringerung des fertigungstechnischen Aufwandes bei der Prüfung,
- Einsparung von automatischen, pressluftbetriebenen Driftsystemen,
- Verringerung der Störzeiten durch im Rohr festsitzende Driftdome,
- schnelle Aussage über die maximale Driftlänge bzw. den maximalen Driftdurchmesser und damit schnelle Entscheidungshilfe für den Betrieb, ob die Rohre nachgearbeitet oder für einen anderen Auftrag verwendet werden können,
- die Angabe der Position, an der der Driftdorn stecken bleiben würde, ermöglicht eine gezielte Nacharbeit.

## Patentansprüche

1. Verfahren zur Überprüfung der Driftbarkeit von metallischen Rohren, bei dem zur Sicherstellung eines vorgegebenen Innendurchmessers und einer Mindestgeradheit ein zylindrischer Driftkörper mit definiertem Durchmesser, definierter Länge und mit einer definierten Kraft durch das Rohr hindurchgeführt wird
**dadurch gekennzeichnet,**
**dass** ein virtuelles Driften vorgenommen wird, wobei unter Verwendung von zuvor ermittelten ortsgenauen Messdaten für den Außendurchmesser und die Wanddicke über den Umfang und die gesamte Rohrlänge sowie Messdaten oder angenommenen Werten für die Geradheit eine vollständige geometrische Beschreibung des Rohres in Form einer dreidimensionalen Abbildung erfolgt und anschließend mittels mathematischer Simulation ein virtueller zylindrischer Driftkörper mit vorgegebener Länge und vorgegebenem Durchmesser virtuell durch das Rohr geschoben wird, wobei über einen Vergleich von ortsgleichen Geometriewerten von Rohr und Driftkörper eine Aussage über die Driftbarkeit des Rohres abgeleitet wird.

2. Verfahren nach Anspruch 1
**dadurch gekennzeichnet,**
**dass** durch Iteration die Driftbarkeit des Rohres für unterschiedliche Durchmesser und Längen des Driftkörpers ermittelt wird.

## Claims

1. A method for testing the driftability of metal tubes, in which, in order to ensure a predetermined internal diameter and a minimum straightness, a cylindrical drift body with a defined diameter, a defined length and with a defined force is guided through the tube,
**characterised in that**
virtual drifting is carried out, with a complete geometric description of the tube in the form of a three-dimensional image taking place using previously-determined measurement data at precise locations for the external diameter and the wall thickness over the circumference and the entire tube length and also measurement data or assumed values for the straightness, and then a virtual cylindrical drift body with a predetermined length and a predetermined diameter is pushed virtually through the tube by means of mathematical simulation, with information on the driftability of the tube being derived by a comparison of geometric values of the tube and the drift body at identical locations.

2. A method according to Claim 1, **characterised in that** the driftability of the tube is determined for different diameters and lengths of the drift body by iteration.

## Revendications

1. Procédé de contrôle de la capacité de mandrinage de tubes métalliques, dans lequel, pour garantir un diamètre interne prédéterminé et une rectitude minimale, un corps de mandrinage cylindrique de diamètre défini, de longueur définie et de force définie est enfilé à travers le tube,
**caractérisé en ce que** l'on effectue un mandrinage virtuel, dans lequel, en utilisant des données de mesure précises déterminées au préalable pour le diamètre externe et l'épaisseur de paroi sur la périphérie et la longueur totale du tube, ainsi que des données de mesure ou des valeurs simulées pour la rectitude, on procède à une description géométrique complète du tube sous la forme d'une représentation tridimensionnelle et, ensuite, par simulation mathématique, un corps de mandrinage cylindrique virtuel de longueur prédéterminée et de diamètre prédéterminé est enfilé virtuellement à travers le tube et, via une comparaison de valeurs géométriques égales du tube et du corps de mandrinage, on en tire une expression de la capacité de mandrinage du tube.

2. Procédé selon la revendication 1,
**caractérisé en ce que**
la capacité de mandrinage du tube est déterminée par itération pour des diamètres et des longueurs différents du corps de mandrinage.
